# EUROPÄISCHE PATENTSCHRIFT

(11) **EP 0 691 683 B1**
(45) Veröffentlichungstag und Bekanntmachung des Hinweises auf die Patenterteilung: **31.05.2000**
(21) Anmeldenummer: 95110474.4
(22) Anmeldetag: 05.07.1995
(51) Int. Cl.: H01L 27/02

(54) **Integrierte Schaltung mit Schutzstruktur**
Integrated circuit with protection structure
Circuit intégré avec structure de protection

(30) Priorität: 06.07.1994 DE 4423591
(43) Veröffentlichungstag der Anmeldung: 10.01.1996
(73) Patentinhaber: Micronas Intermetall GmbH, 79108 Freiburg (DE)
(72) Erfinder: Obermeier, Cornelius, Dipl.-Ing., D-79232 March-Buchheim (DE)

(56) Entgegenhaltungen:
- EP-A- 0 246 139
- EP-A- 0 448 119
- GB-A- 2 281 813
- US-A- 4 691 217
- ELECTRICAL OVERSTRESS/ELECTROSTATIC DISCHARGE SYMPOSIUM PROCEEDINGS, 1991 NEW ORLEANS, USA, Seiten 88-97, XP 000391402 C. DUVVURY ET AL. 'A SYNTHESIS OF ESD INPUT PROTECTION SCHEME'

## Beschreibung

Die Erfindung betrifft eine Schutzstruktur zum Schutz eines Ausgangs oder Eingangs einer integrierten Schaltung (IC) gegen Überspannungen mit einem n-Kanal-MOS-Feldeffekt-Transistor (Transistor) gegen Überspannungen mit einem n-Kanal -MOS-Feldeffekt-Transistor.

Eine ähnliche Schutzstrukturen ist aus der WO-A-9 510 855 bekannt.

Dieses Dokument gehört zum Stand der Technik gemäß Art. 54(3) EPÜ.

Eine solche Schutzstruktur dient dazu, das IC gegen elektrostatische Entladungsströme zu schützen, die auf Pins des IC's gelangen können. Solche Entladungsströme können beispielsweise beim Handhaben des IC's aufgrund von Entladungen elektrisch aufgeladener Körper, beispielsweise durch einen Menschen, durch Metallwerkzeuge, durch ein Gehäuse etc. auf die Pins gelangen.

Aus EOS/ESD Symposium Proceedings 1991, S.88, Charvaka Duvvury und Robert Rountree ist eine Schutzanordnung für integrierte Schaltungen (IC) mit einem n-Kanal-MOS-Feldeffekt-Transistor (Transistor) bekannt, die gegen elektrostatische Überlastung von Eingängen oder Ausgängen vorgesehen ist. Hierzu wird der mit dem Pin, d.h. mit dem entsprechenden Ausgang oder Eingang, verbundene Transistor, der stets einen parasitären Bipolar-Transistor enthält, in den Bipolar-Zustand gebracht, in welchem er mit hohem Strom bei einer niedrigeren Spannung betrieben werden kann. Dieser Vorgang wird als "snap-back" bezeichnet. Aufgrund der Erniedrigung der Spannung infolge des Bipolarbetriebs kann der Transistor mehr Leistung aufnehmen. Zum weiteren Schutz des Transistors soll der Übergang in den Bipolarzustand möglichst schnell erfolgen und der Bipolarzustand soll möglichst stabil gehalten werden, da ein zweites "snap-back", der "second breakdown" des Bipolartransistors, diesen zerstören würde.

Der Erfindung liegt die Aufgabe zugrunde, die Schutzstruktur zu vereinfachen.

Diese Aufgabe wird durch die Merkmale des Patentanspruchs 1 gelöst.

Bei dieser Anordnung besteht die Drain-Gate-Kante, wie bei üblichen n-Kanal-MOS-Transistoren, aus einem flachen, hochdotieren pn-Übergang. Damit ist eine niedrige Abbruchsspannung für den Übergang in den Bipolarbetrieb, also für den snap-back-Vorgang gewährleistet, welcher somit schnell erfolgt. Aufgrund der erfindungsgemäß angeordneten n-dotieren Widerstandszone erstreckt sich nahe der Drain-Kante diese schwächer dotierte Widerstandszone weiter in das Innere des Substratkörpers. Dadurch wird die Gefahr thermischer Überlastung bei dem Übergang in den bipolaren Zustand vermieden. Dies läßt sich dadurch erklären, daß bei der Abbruchspannung Stromeinschnürungen an dem pn-Übergang auftreten, welche sich nunmehr entlang der Drain-/Gatekante verteilen. Ebenfalls werden thermische Störeffekte aufgrund der Metall-Anschlußkontakte in der Drain-Anschlußzone auf die Drain-Zone und damit auf die Wirkungsweise des Transistors verhindert. Denn wegen der Widerstandszone besteht zwischen der Drain-/Gatekante und den Anschlußkontakten ein großer Abstand, so daß die Wärmeleitung zu den Anschlußkontakten über eine größere Strecke erfolgt. Aufgrund der erfindungsgemäßen Anordnung besteht zwischen der Drain-Zone und der Drain-Anschlußzone an der Oberfläche des Substratkörpers eine gemäß der Widerstandszone dotierte n-Zone, welche nicht mit der n-Dotierung der Drain-Zone und der Drain-Anschlußzone überbrückt ist. Die Drain-Zone und die Drain-Anschlußzone können die gleiche n-Dotierung aufweisen. Zusätzlich zu dem Vorteil, daß aufgrund der erfindungsgemäßen Anordnung eine lokale Überhitzung, was auch die Bildung von "hot spots" genannt wird, beim Übergang in den bipolaren Zustand des Transistors verhindert wird, erhält man auch eine sehr platzsparende Anordnung, da kein zusätzliches Widerstandselement angeordnet werden muß, da die Widerstandszone in dem Substratkörper integriert ist. Ferner kann der n-Kanal-Transistor ohne Zusatzschritte und ohne zusätzliche Masken bei dem normalen MOS-Prozeß zur Herstellung des IC's hergestellt werden.

Der erfindungsgemäße Transistor kann zum Schutz des Ausgangs eines IC's verwendet werden. Er kann dann selbst die Ausgangsstufe des IC's bilden, so daß kein separates Bauteil für die Schutzeinrichtung erforderlich ist. Hierdurch kann in der Chiptechnologie Platz gespart werden. Der erfindungsgemäße Transistor findet seine Verwendung z.B. als Teil einer Push-Pull-Stufe und wird auch in kombinierten Ausgängen und Eingängen in der CMOS-Technologie verwendet. Bei der Verwendung zum Schutz eines Eingangs eines IC's wird die Drainzone der Schutzstruktur über ihren Anschluß niederohmig mit einem Eingangselement, z.B. einer Gateelektrode eines Transistors verbunden. Dabei wird die Gateelektrode auf das Sourcepotential gelegt, für welches üblicherweise das Massepotential verwendet wird. Ebenfalls wird die erfindungsgemäße Schutzstruktur zwischen Versorgungsleitungen, insbesondere der positiven Versorgungsleitung und der Masse, eines IC's oder einer Teilschaltung eines IC's verwendet.

Gemäß einem bevorzugten Ausführungsbeispiel der Erfindung erstreckt sich die Widerstandszone höchstens bis zu der Gate-/Drainkante der Drain-Zone. Hierdurch wird eine gute Ankopplung der Widerstandszone an die Drain-Zone bewirkt. Dabei kann ein möglichst großer Bereich der Drain-Zone bedeckt werden, die dadurch begrenzt wird, daß der unterhalb der Gate-Elektrode zwischen der Source-Zone und der Drain-Zone gebildete Kanal in seiner Größe nicht beeinträchtigt wird. Günstigerweise erstreckt sich die Widerstandszone unterhalb der gesamten Drain-Anschlußzone, so daß eine gute Kontaktierung zwischen der Widerandszone und der Drain-Anschlußzone gewährleistet ist. Günstigerweise beträgt die Bereite des Widerstandszone mehr als 10 µm vorzugsweise 100 µm. Dies ist bei den üblichen Dimensionen von MOS-n-Kanal-Transistoren hoher Leistung und damit kleiner Abmessung eine günstige Größe. Die Breite der Widerstandszone ist dann etwas größer als die Breite des Transistors. Es ist vorteilhaft, die n-Wanne des CMOS-Prozesses als Widerstanszone zu verwenden.

Ferner ist es vorteilhaft, wenn die Tiefe der Widerstandszone deutlich größer ist als die Tiefe der Drain-Zone bzw. der Drain-Anschlußzone, insbesondere um den Faktor 3 bis 5. Die Tiefe ist entsprechend der gewünschten Funktion des einzelnen Transistors wählbar. Unter deutlich größer kann auch ein Faktor 1,5 verstanden werden.

Gemäß einer vorteilhaften Weiterbildung der Erfindung kann unterhalb der Source-Zone eine n-Zone mit schwächerer Dotierung als die Dotierung der Source-Zone ausgebildet sein. Hierdurch wird auch dort das Auftreten von elektrischen Kurzschlüssen durch Legierungseffekte aufgrund der metallischen Elektrodenanschlüsse verhindert.

Der Drainbereich ist über einen Anschluß direkt mit einem Eingangselement, insbesondere einer Gateelektrode eines Eingangstransistors des zu schützenden IC's verbunden.

Die aufgrund der erfindungsgemäßen Anordnung des Transistors bewirkte Schutzfunktion gegen elektrostatische Aufladung wirkt auch bei Transistoren mit sehr geringer Tiefe der Source- und Drainanschlüsse, die bei schnellen Schaltungen verwendet werden. Solche Transistoren können auch mit Erfolg bei siliziierten Techniken ausgebildet und verwendet werden. Dies gilt sowohl, wenn nur eine der Gate-, Source- bzw. Drain-Zonen oder alle siliziiert sind. Bei derartigen Transistoren ist ein erfindungsgemäß ausgelegter Transistor besonders vorteilhaft. Denn siliziierte Zonen sind sehr niederohmig, und dadurch sind normalerweise solche Transistoren bei elektrostatischen Bedingungen besonders gefährdet. Hier kommt die Schutzwirkung der Widerstandszone besonders zum Tragen.

Im folgenden wird die Erfindung anhand der Figuren näher erläutert.

Es zeigen:
Fig. 1 eine Draufsicht auf eine erfindungsgemäße Anordnung zweiter parallelgeschalteter Transistoren und
Fig. 2 einen Querschnitt durch die erfindungsgemäße Anordnung der Fig. 1.

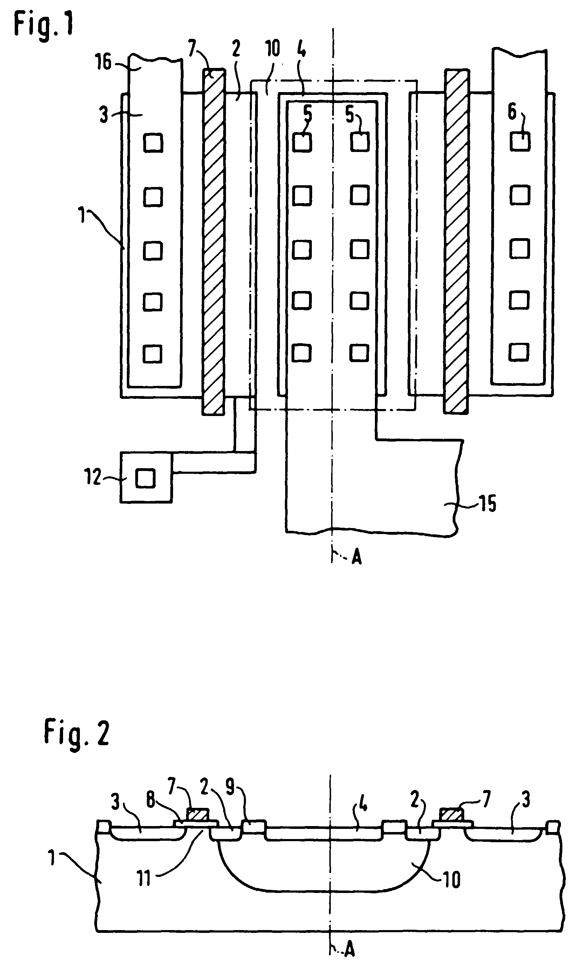

Auf einem p-dotieren Substratkörper 1 sind für jeden der beiden n-Kanal-Transistoren eine Drain-Zone 2 und eine Source-Zone 3 ausgebildet. Ferner ist eine von den Drain-Zonen 2 getrennt angeordnete Drain-Anschluß-Zone 4 vorgesehen, welche für beide Transistoren gemeinsam verwendet wird. Auf der Drain-Anschluß-Zone 4 sind, wie man der Fig. 1 entnimmt, Drain-Anschlüsse 5 für beide Transistoren vorgesehen. Die Source-Anschlüsse 6 sind auf der jeweiligen Source-Zone 3 der beiden Transistoren vorgesehen. Zwischen der Drain-Zone 2 und der Source-Zone 3 der Transistoren ist jeweils eine Gate-Elektrode 7 auf einer Isolierschicht 8 vorgesehen. Zwischen der Drain-Zone 2 und der Drain-Anschlußzone 4 ist jeweils eine Feldoxidschicht angeordnet, welche die Drain-Zone 2 von der Drain-Anschlußzone 4 isoliert. Die Anordnung der beiden Transistoren ist spiegelsymmetrisch zu der Symmetrieachse A. Zur Kontaktierung der Drain-Anschlüsse 5 und der Source-Anschlüsse 6 sind auf den Drain- bzw. Source- Bereichen Leiterbahnen 15 bzw. 16 aufgebracht, die typischerweise aus Aluminium bestehen und zu einem Kontaktanschluß (Pad) führen.

Unterhalb der Drain-Zonen 2 und der Drain-Anschlußzonen 4 ist eine n-Wanne 10 vorgesehen, welche eine niedrigere Dotierung als die Drain-Zonen 2 und die Drain-Anschlußzonen 4 aufweist. Da die Drain-Zonen 2 von den Drain-Anschlußzonen 4 mittels der Feldoxidschichten 9 voneinander isoliert sind, erfolgt die elektrische Leitung zwischen den Drain-Zonen 2 und der Drain-Anschlußzone 4 über die n-Wanne 10. Die n-Wanne 10 erstreckt sich unterhalb der gesamten Drain-Anschlußzone 4 und bis in die Nähe der Gate-/Drain-Kante der Drain-Zonen 2. Hierdurch ist ein guter Kontakt zwischen der n-Wanne 10 und den Drain-Zonen 2 sowie den Drain-Anschlußzonen 4 gewährleistet. Die n-Wanne 10 erstreckt sich nicht ganz bis zu der Gate-/Drain-Kante, so daß der zwischen der jeweiligen Drain-Zone und der jeweiligen Source-Zone 3 eines Transistors bestehende Kanal 11 unterhalb der Gate-Elektrode 7 nicht durch die n-Wanne verschmälert wird. Die n-Wanne 10 ist ferner so ausgebildet, daß sie um ein Vielfaches der Tiefe der Drain-Zonen 2 in den Substratkörper 1 hineinreicht, so daß hierdurch der pn-Übergang weiter in das Innere des Substratkörpers verlegt wird. Hierdurch entsteht ein tieferer aber schwächer dotierter pn-Übergang als der zwischen der Drain-Zone 2 und der Kanalzone 11. Mit einem Anschluß 12 wird die Schutzanordnung mit einem Eingangselement des IC's, z.B. einer Gateelektrode eines Eingangstransistors verbunden.

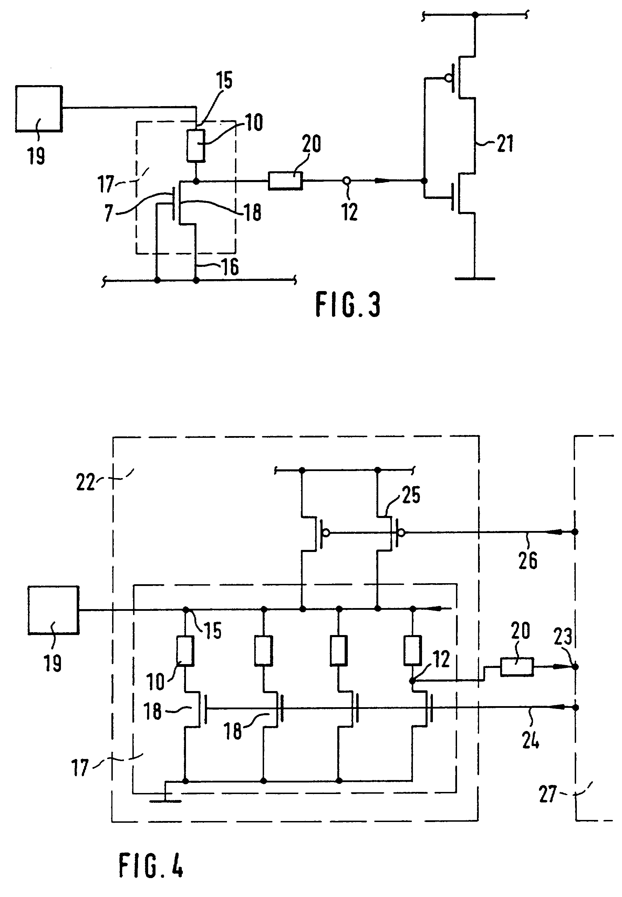

In Fig. 3 ist die Verwendung der erfindungsgemäßen Schutzstruktur als Eingang eines IC's gezeigt. Die Schutzstruktur 17 zeigt dabei den Transistor 18, zu dem der durch die Widerstandszone 10 gebildete Widerstand in Reihe geschaltet ist. Die mit der Drain-Anschlußzone verbundene Leiterbahn 15 führt zu einem äußeren Anschlußpad 19, über welches das IC mit äußeren Anschlüssen verbunden werden kann. Der Transistor 18 ist in diesem Fall als Diode geschaltet, wobei die Leiterbahn 16 von den Source-Anschlüssen und die Gate-Elektrode 7 mit einem festen Potential, vorzugsweise der Masse verbunden sind. Der Drainbereich des Transistors 18 ist mit seinem Anschluß 12 mit einem Eingangselement 21 des IC's, d.h. des inneren Teils des IC's verbunden. Hier ist das Eingangselement eine CMOS-Inverterstufe.

In Fig. 4 ist eine weitere Verwendungsmöglichkeit der erfindungsgemäßen Schutzstruktur 17 gezeigt. Die Schutzstruktur 17 wird hier als Teil einer Push-Pull-Ausgangsstufe 22 eines IC's verwendet. Die Schutzstruktur 17 besteht aus mehreren zueinander parallelgeschalteten Transistoren 18, zu deren Drain jeweils ein durch den Widerstandsbereich 10 gebildeter Widerstand in Reihe geschaltet ist. Der Drainanschluß 15 führt zu einem Anschlußpad 19, welches ein Eingangs/Ausgangsanschlußpad ist. Die parallelgeschalteten Transistoren 18 mit ihren Widerstandsbereichen 10 entsprechen einer Schutzstruktur wie sie in Fig. 1 gezeigt ist, mit mehreren parallelgeschalteten Anschlüssen. Der Anschluß 12 der Drainbereiche der Schutzstruktur 17 führt über einen Widerstand 20 zu einem Eingang 23 des inneren Teils des IC's. Die Gate-Elektroden werden von einer aus dem inneren Teil 27 des IC's kommenden Signalleitung 24 angesteuert. Ebenfalls werden die Gate-Elektroden der p-Kanal-Transistoren 25, die den zweiten Zweig der Push-pull-Stufe bilden, von einer Signalleitung 26, die ebenfalls aus dem inneren Teil 27 des IC's kommt, angesteuert. In der Regel ist das W/L-Verhältnis der Transistoren 25 des zweiten Zweiges deutlich größer als das W/L-Verhältnis der Transistoren 18 des ersten Zweiges der Push-Pull-Stufe.

Im folgenden wird die Funktionsweise der erfindungsgemäßen Transistoranordnung beschrieben. Gelangt ein positiver Spannungspuls beispielsweise über einen äußeren Anschluß des IC's auf die mit diesem Anschluß verbundene Drainanschlußzone, so geht der n-Kanal-MOS-Transistor beim Erreichen der Drain-Source- bzw. der Drain-Substrat-Abbruchspannung in einen bipolaren Betriebszustand über. Dieser Betriebszustand wird auch mit npn-Zustand bezeichnet. Die Leiterbahnen 16 werden typischerweise an Masse angeschlossen. Die n-Wanne 10 bildet einen Serienwiderstand zwischen der Drain-Zone 2 und der Drain-Anschlußzone 4. Ferner bildet sie einen tief in den Substratkörper 1 hineinreichenden pn-Übergang zwischen der Drain-Zone 2 und dem Kanal 11 aus, den Collector-pn-Übergang. Aufgrund des Serienwiderstands dieser n-Wanne werden bei dem Übergang in den pn-Zustand Einschnürungen des an dem pn-Übergang auftretenden Stromes verhindert. Der Transistor kann im Bipolarzustand mehr Leistung als mit herkömmlichen Anordnungen aufnehmen. Durch das Parallelschalten zweier oder mehrerer Transistoren wird der dabei auftretende Strom noch weiter verteilt, so daß die Leistung von beiden Transistoren aufgenommen werden kann, da die Verlustleistung auf eine noch größere Fläche verteilt wird.

## Patentansprüche

1. Integrierte Schaltung mit einem Eingang oder Ausgang sowie einer Schutzstruktur zum Schutz des Eingangs oder Ausgangs gegen Überspannung, wobei diese Schutzstruktur einem n-Kanal-MOS-Feldeffekttransistor enthält bei dem die Drain-Zone (2) und die Drainanschlußzone (4) räumlich getrennt voneinander angeordnet sind, im Substrat (1) unterhalb der Drain-Zone (2) und der Drain-Anschlußzone (4) eine n-dotierte Widerstandszone (10) mit einer schwächeren Dotierung als die Dotierung der Drain-Zone (2) und der Drain-Anschlußzone (4) derart ausgebildet ist, daß sie die elektrisch leitende Verbindung zwischen der Drain-Zone (2) und der Drain-Anschlußzone (4) bildet, und die Drain-Anschlußzone (4) mit einem äußeren Anschlußpad (19) verbunden ist, wobei die Drain-Zone (2) direkt mit einem Eingangselement des ICs verbunden ist.

2. Integrierte Schaltung nach Anspruch 1, dadurch gekennzeichnet, daß sich die Widerstandszone (10) höchstens bis zu der Gate-/Drain-Kante der Drain-Zone (2) erstreckt.

3. Integrierte Schaltung nach Anspruch 1 oder 2, dadurch gekennzeichnet, daß die Widerstandszone (10) sich unterhalb der gesamten Drain-Anschlußzone (4) erstreckt.

4. Integrierte Schaltung nach einem der vorangehenden Patentansprüche, dadurch gekennzeichnet, daß die Drainzone (2) und die Drainanschlußzone (4) durch eine Isolationsschicht voneinander getrennt sind, welche an der Halbleiteroberfläche liegt.

5. Integrierte Schaltung nach einem der vorangehenden Patentansprüche, dadurch gekennzeichnet, daß die Breite der Widerstandszone (10) mehr als 10 µm, vorzugsweise 100 µm beträgt.

6. Integrierte Schaltung nach einem der vorangehenden Patentansprüche, dadurch gekennzeichnet, daß die Tiefe der Widerstandszone (10) deutlich größer ist als die Tiefe der Drain-Zone (2) bzw. der Drain-Anschlußzone (4), insbesondere um einen Faktor 3 bis 5.

7. Integrierte Schaltung nach einem der vorangehenden Patentansprüche, dadurch gekennzeichnet, daß unterhalb der Source-Zone (3) eine n-Zone mit schwächerer Dotierung als die Dotierung des Source-Zones (3) ausgebildet ist.

## Claims

1. An integrated circuit having an input or output as well as a protection structure for protecting the input or output against overvoltage, said protection structure comprising an n-channel MOS field-effect transistor wherein the drain region (2) and the drain contact region (4) are spatially separated from each other, wherein below the drain region (2) and the drain contact region (4), an n-type resistor region (10) doped more lightly than the drain region (2) and the drain contact region (4) is formed in the substrate (1) to provide an electrical connection between the drain region (2) and the drain contact region (4), and wherein the drain contact region (4) is connected to an external contact pad, with the drain region (2) being connected directly to an input element of the integrated circuit.

2. An integrated circuit as claimed in claim 1, characterized in that the resistor region (10) does not extend farther than the gate/drain edge of the drain region (2).

3. An integrated circuit as claimed in claim 1 or 2, characterized in that the resistor region (10) extends below the entire drain contact region (4).

4. An integrated circuit as claimed in any one of the preceding claims, characterized in that the drain region (2) and the drain contact region (4) are separated by an insulating layer located at the semiconductor surface.

5. An integrated circuit as claimed in any one of the preceding claims, characterized in that the width of the resistor region (10) is more than 10 µm, preferably 100 µm.

6. An integrated circuit as claimed in any one of the preceding claims, characterized in that the depth of the resistor region (10) is substantially greater than the depth of the drain region (2) or the drain contact region (4), particularly by a factor of 3 to 5.

7. An integrated circuit as claimed in any one of the preceding claims, characterized in that below the source region (3) an n-type region doped more lightly than the source region (3) is provided.

## Revendications

1. Circuit intégré comprenant une entrée ou une sortie ainsi qu'une structure de protection pour la protection de l'entrée ou de la sortie contre les surtensions, la structure de protection comprenant un transistor à effet de champ du type MOS à canal N, dans lequel la zone de drain (2) et la zone de connexion de drain (4) sont disposées en étant séparées spatialement l'une de l'autre, dans lequel, dans le substrat (1), en dessous de la zone de drain (2) et de la zone de connexion de drain (4), une zone de résistance à dopage N (10) ayant un dopage plus faible que le dopage de la zone de drain (2) et de l'unité de commande 4 est conformée de telle manière qu'elle constitue la liaison électriquement conductrice entre la zone de drain (2) et la zone de connexion de drain (4) et dans lequel la zone de connexion de drain (4) est reliée à une plage de connexion extérieure (19), la zone de drain (2) étant reliée directement à un élément d'entrée du circuit intégré.

2. Circuit intégré selon la revendication 1, caractérisé en ce que la zone de résistance (10) s'étend au plus jusqu'à la transition grille-drain de la zone de drain (2).

3. Circuit intégré selon la revendication 1 ou 2, caractérisé en ce que la zone de résistance (10) s'étend en dessous de l'ensemble de la zone de connexion de drain (4).

4. Circuit intégré selon l'une quelconque des revendications précédentes, caractérisé en ce que la zone de drain (2) et la zone de connexion de drain (4) sont séparées par une couche isolante qui repose sur la surface semi-conductrice

5. Circuit intégré selon l'une quelconque des revendications précédentes, caractérisé en ce que la largeur de la zone de résistance (10) est supérieure à 10 µm, de préférence de 100 µm.

6. Circuit intégré selon l'une quelconque des revendications précédentes, caractérisé en ce que l'épaisseur de la zone de résistance (10) est beaucoup plus grande que l'épaisseur de la zone de drain (2) ou de la zone de connexion de drain (4), en particulier d'un facteur de 3 à 5.

7. Circuit intégré selon l'une quelconque des revendications précédentes, caractérisé en ce que, au dessous de la zone de la source (3), une zone N à dopage plus faible que le dopage de la zone de la source (3) est formée.
